# EUROPEAN PATENT SPECIFICATION

(11) **EP 3 076 427 B1**
(45) Date of publication and mention of the grant of the patent: **15.07.2020**
(21) Application number: 15275097.2
(22) Date of filing: 30.03.2015
(51) Int. Cl.: H01L 23/36, H01L 25/07, H01L 23/473, H01L 23/40, H01L 23/367, H02M 1/08, H02M 7/00

(54) **ELECTRICAL ASSEMBLY**
ELEKTRISCHE BAUGRUPPE
ENSEMBLE ÉLECTRIQUE

(43) Date of publication of application: 05.10.2016
(73) Proprietor: General Electric Technology GmbH, 5400 Baden (CH)
(72) Inventor: DAVIDSON, Colin Chamrock, Stafford ST17 4PS (GB); VERSHININ, Konstantin, Stafford ST17 0PS (GB)
(74) Representative: Freigutpartners IP Law Firm

(56) References cited:
- DE-A1- 19 545 448
- DE-A1-102011 085 982
- JP-A- H08 290 225
- US-A1- 2010 259 927
- US-A1- 2011 079 370

## Description

This invention relates to an electrical assembly. The electrical assembly may include a plurality of semiconductor devices arranged in a stack with associated heat sinks. The invention also relates to a converter including the electrical assembly and a kit of parts for the electrical assembly.

DE 10 2011 085982 describes a heat sink system for an electrical device having at least two heat sink segments that can be interconnected for assembly, wherein at least one heat sink segment has an assembly profile on at least one side for the assembly-ready connection to a housing part, wherein at least two heat sink segments can be interconnected and one heat sink segment and one housing part can be interconnected so as to be ready for assembly without screws.

US 2010/259927 describes an LED lamp structure including a lamp body having a front side, on which a recess is defined and a plurality of conducting wires and a metal foil are provided in the recess; and a rear side, on which a plurality of radiating fins is provided. A plurality of LED chips is mounted on the metal foil on the lamp body and electrically connected to the conducting wires on the lamp body through wire bonding. An encapsulating material being filled in the recess to complete packaging of the LED chips while light emitted from the LED chips can transmit through the encapsulating material; and a lens being mounted to the front side of the lamp body includes a lamp body, a plurality of LED chips, a lens, and an expansion structure. A plurality of the lamp bodies can be connected side-by-side, end-to-end and/or back-to-back via the expansion structure to expand the LED lamp structure.

US 2011/079370 describes a heat sink including a heat sink plate and a heat generating electrical component mounted to a first side of the heat sink plate. Fins are connected and oriented perpendicular to a second side of the heat sink plate. The fins include a maximum height fin positioned proximate to the electrical component, and a minimum height fin spatially separated from the maximum height fin and the electrical component. A first group of fins is positioned between the maximum and minimum height fins. Each fin of the first group progressively decreases in height from a height of the maximum height fin to a height of the minimum height fin. A first spacing between the maximum height fin and a proximate one of the fins of the first group is less than a second spacing between any two consecutive ones of the first group of fins.

The present invention resides in an electrical assembly as defined in the appended claims.

The configuration of the present invention is advantageous as the heat sink for each "module", which comprises the first and second electrical components, is releasably separable into two parts. Maintenance of the assembly is easy as the secondary heat sink can be detached from the first heat sink, with its electrical components attached thereto. For example, if a faulty secondary electrical component is identified, the secondary heat sink can be replaced as a complete unit along with the faulty electrical components. Further, the thermal coupling between the primary and secondary heat sinks allows for heat transfer between the two heat sinks to provide for efficient heat dissipation over both heat sinks rather than the two (primary and secondary) heat sinks individually.

In the stack arrangement, the primary heat sinks may be interleaved with the primary electrical components and clamped together. This arrangement may be advantageous as each primary electrical component has two surfaces in contact with a heat sink (i.e. its associated primary heat sink and an adjacent primary heat sink in the stack). The stack may include a tertiary heat sink for contacting a second side of a primary electrical component located at an end of the stack, where the first side, opposed to the second side, contacts its associated primary heat sink. Thus, the tertiary heat sink may be substantially similar to a primary heat sink but does not carry its own primary electrical component as it is configured to provide a "second" heat sink for a "top-most" primary electrical component in the stack. The tertiary heat sink may be configured to receive a heat transfer fluid, similar to that described for the primary heat sink.

Optionally, each primary heat sink is configured to receive a flow of a heat transfer fluid to actively cool said primary heat sink. Thus, the primary heat sink may include conduits therethrough configured such that the heat transfer fluid or coolant can be flowed through the primary heat sink. The heat transfer fluid may comprise water or glycol, such as ethylene glycol or propylene glycol, or a mixture of water and glycol. The water may be deionized which may prevent problems associated with electrolytic corrosion. Thus, the primary heat sink may form part of a coolant circuit in which heat transfer fluid is flowed through the primary heat sink and then through a radiator to dissipate the heat received by the primary heat sink, which may be from the secondary heat sink via the heat transfer surfaces.

Optionally, each secondary heat sink is configured to passively cool the secondary electrical component without a flow of heat transfer fluid at least by virtue of its thermal coupling with the adjacent primary heat sink. Thus, the heat transfer surfaces of the primary heat sink and the secondary heat sink over which the two heat sinks are coupled may be free from heat transfer fluid flow ports. Accordingly, heat generated by the secondary electrical component may be dissipated by the secondary heat sink to atmosphere, via fins and/or radiatively, and also to the primary heat sink and to the heat transfer fluid that flows therethrough. The passive nature of the secondary heat sink may allow for easy decoupling of the secondary heat sink from the primary heat sink as few connections require disconnection. For example, a mechanical retention element and/or an electrical connection may be the only disconnections required to decouple the primary and secondary heat sinks.

Optionally, each primary heat sink and the adjacent secondary heat sink include complementary parts of a releasable physical retention element configured to physically hold the primary and secondary heat sinks together when coupled. The physical retention element may be provided any one of; a clip and a detent; a magnetic coupling; an interference fit; a bolt and aperture; or releasable adhesive pads.

Optionally, each primary heat sink includes one of a projecting plug part and a complementary socket part and the adjacent secondary heat sink includes the other, the plug part configured to be received by the socket part when the primary heat sink and the secondary heat sink are coupled, the plug part and socket part each comprising the respective heat transfer surface to transfer heat between the secondary heat sink and the primary heat sink. The physical retention element may be provided by the plug and socket. The primary heat sink may include the plug part and the secondary heat sink may include the socket part. This arrangement may be advantageous as the plug part may be easier to clean and maintain while the secondary heat sink is removed, particularly if the primary heat sink is part of a clamped assembly. The clamped assembly may comprise a plurality of primary heat sinks interleaved with the primary electrical components and clamped together. The projection may be received wholly within the socket or the socket may receive only part of the projection. The plug may be tapered from a proximal end to a narrower distal end. A plurality of plugs or "projections" may extend from the heat transfer surface to be received by a complimentary plurality of sockets or "recesses". Further, each heat transfer surface may comprise a combination of projections and recesses. The plug and socket may be embodied as a wedge shape that contacts a further wedge shape wherein the heat transfer surfaces are provided by the wedge shaped plug and socket.

One or more of the plug(s) or projection(s) of the first heat sink may include a conduit for receiving the heat transfer fluid. Likewise, a socket or recess of the first heat sink and the conduit for the heat transfer fluid may be arranged such that the conduit extends around side walls of the socket.

Optionally, the secondary heat sinks of the stack are arranged relative to the primary heat sinks such that they are individually removable from their associated primary heat sink without unclamping of the clamping arrangement of the primary heat sinks in the stack. Thus, while the secondary heat sinks can be considered to be an extension of the primary heat sinks, they are arranged such that they are not subject to the clamping force of the clamping arrangement such that they are conveniently removable from the clamped primary heat sinks.

Optionally, each semiconductor device comprises one or more of; a thyristor, an insulated-gate bipolar transistor (IGBT), a gate-turn-off thyristor (GTO), a Gate Commutated

Thyristor (GCT), an Integrated Gate Commutated Thyristor (IGCT) and an Injection Enhanced Gate Transistor (IEGT). It will be appreciated that the semiconductor device may comprise a plurality of semiconductor devices. Further, in other aspects, the first electrical component may not necessarily comprise a semiconductor device.

Optionally, each secondary electrical component comprises at least one of;
a grading resistor comprising a resistor configured to improve the distribution (grading) of voltage amongst series connected semiconductor devices in the electrical assembly;
a snubber capacitor comprising a capacitor configured to suppress voltage transients during switching of the semiconductor device;
a damping circuit such as a Resistor-Capacitor circuit configured to damp any oscillatory behaviour experienced at switching of the semiconductor device;
a controller configured to control, monitor or provide feedback from the semiconductor device.

Thus, the secondary electrical component may comprise a component part of a switching circuit of which the primary electrical component forms a switching element. In one embodiment, the semiconductor device comprises a three terminal device (such as anode, cathode and gate for a thyristor) and all three terminals are configured to be electrically connected to one or more secondary electrical components of the secondary heat sink.

Optionally, each secondary heat sink includes at least one heat pipe having a working fluid therein for transferring thermal energy from an evaporator end to a condensing end, the condensing end arranged adjacent the heat transfer surface of the secondary heat sink. The condensing end may be arranged adjacent the heat transfer surface of the secondary heat sink and the evaporator end may be arranged spaced from the heat transfer surface and extending into the body of the secondary heat sink, such as towards the secondary electrical component. This may aid efficient transfer of heat from the secondary electrical component to the adjacent primary heat sink.

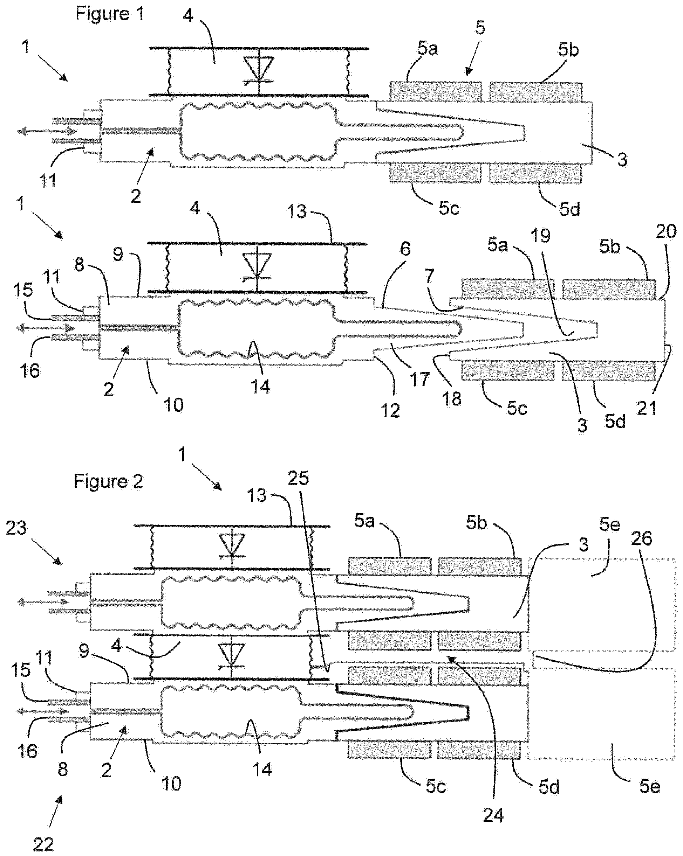

Optionally, each primary heat sink comprises an elongate body (in section) having a plurality of elongate sides separating two end faces wherein the primary electrical component is mounted to at least one of the elongate sides and the secondary heat sink is thermally coupled to one of the end faces. In one example, the primary heat sink is plate shaped and may be substantially cuboidal in which the width of the primary heat sink, which extends into and out of the page in figure 1, is substantially the same as the length, which extends left to right in figure 1, between the end faces. Thus, the primary heat sink has two larger faces to contact the primary electrical components and four smaller, narrower faces, two of which form the end faces. Thus, the primary heat sink may comprise a plate having a first and a second larger face and four smaller faces, wherein the primary electrical component is mounted to at least one of the larger faces and the secondary heat sink is thermally coupled to one of the smaller faces. The end face or one of the smaller faces may include a plug or socket arranged to increase the surface area of the face. The end face or smaller face opposite that which connects to the secondary heat sink (or one of the other smaller faces) may include heat transfer fluid flow ports. Use of the end face, or other smaller faces, to connect the secondary heat sink may be advantageous because when arranged in a stack, the extension of the secondary heat sink from the end face or other smaller face of the primary heat sink does not add to the height of stack.

Optionally, the electrical assembly includes an electrical connector comprising a first electrical connector part and a second electrical connector part for providing an electrical connection between each semiconductor device and the adjacent secondary electrical component, the first electrical connector part associated with the primary heat sink and the second electrical connector part associated with the secondary heat sink. The electrical connector parts may be mounted on their respective heat sinks. The electrical connector may additionally provide the physical retention element.

Optionally, each primary heat sink and the adjacent secondary heat sink are of an electrically conductive material and the coupling between them provides for an electrical connection therebetween, wherein an electrical terminal of the primary electrical component and an electrical terminal of the secondary electrical component are connected together via the primary and secondary heat sinks such that a current path between the electrical components is provided by the heat sinks. Thus, a terminal of the primary electrical component may be electrically coupled to the primary heat sink and a terminal of the secondary electrical component may be electrically coupled to the secondary heat sink.

According to a further aspect of the invention we provide a converter, for transferring power between AC and DC electrical networks, comprising a converter limb portion connected between AC and DC terminals, the AC terminal being connectable to an AC electrical network and the DC terminal being connectable to a DC electrical network, the converter limb portion including the electrical assembly of the first aspect wherein the semiconductor device comprises a switching element operable to facilitate power transfer between the AC and DC terminals during operation of the converter.

The converter may comprise a voltage source converter wherein the primary electrical component comprises a switching element thereof. The converter may comprise a Line Commutated Converter (LCC) HVDC converter. Accordingly, the semiconductor device may comprise a thyristor. It will be appreciated that, typically but not exclusively, the converter includes two limb portions for each phase of the AC electrical network and one or more of the limb portions may be formed in accordance with the electrical assembly of the first aspect.

According to an example, we provide a method of maintaining or replacing a secondary electrical component of an electrical assembly, the electrical assembly comprising a primary electrical component comprising a semiconductor device; a primary heat sink having the primary electrical component mounted thereon to provide a heat sink for said primary electrical component; a secondary electrical component electrically connected or coupled with the primary electrical component; a secondary heat sink having the secondary electrical component mounted thereon to provide a heat sink for said secondary electrical component; wherein the primary heat sink and the secondary heat sink are physically releasably couplable to one another and, when coupled, the primary and secondary heat sinks are thermally coupled by abutment of respective heat transfer surfaces of the primary and secondary heat sinks and wherein the assembly includes a plurality of primary heat sinks and associated primary electrical components arranged in a stack wherein, in the stack, a second primary heat sink positioned adjacent a first primary heat sink in the stack is arranged such the primary electrical component of the first primary heat sink is clamped between the first primary heat sink and the second primary heat sink by a clamping arrangement, the method comprising;
removing a secondary heat sink from the primary heat sink without unclamping the clamping arrangement;
performing maintenance or replacement of the secondary electrical components; refitting the, or fitting a different, secondary heat sink to the primary heat sink.

The different secondary heat sink may include a protective layer over its heat transfer surface that requires removal prior to fitting onto the primary heat sink. The protective layer may comprise a sheet of plastic. The plastic may also cover a layer of thermal grease.

To replace a primary electrical component the method may comprise unclamping the clamping arrangement, separating adjacent primary heat sinks, performing maintenance or replacement of the primary electrical components, re-clamping the clamping arrangement.

The method is particularly applicable when the electrical assembly comprises a stack of a power converter, as described above.

There now follows, by way of example only, a detailed description of embodiments of the invention with reference to the following figures, in which:
Figures 1a and 1b show a side view of an electrical assembly comprising primary and secondary heat sinks in coupled and uncoupled positions;
Figure 2 shows an electrical assembly comprising a stack;
Figure 3 shows a schematic electrical diagram of electrical connections between primary and secondary electrical components;
Figure 4 shows a further example of the electrical assembly;
Figure 5 shows a still further example of the electrical assembly;
Figure 6 shows another example of the electrical assembly; and
Figure 7 shows, schematically, an example converter.

Electrical components may require cooling to operate efficiently and/or reliably. Cooling of electrical components may also be important when a plurality of electrical components are mounted together in an assembly where each electrical component comprises a source of heat, particularly when the assembly is compact. Heat sinks can be used to conduct heat or thermal energy away from the electrical components. Heat sinks may be passive in that they provide a radiative surface to transfer heat to atmosphere or they may be active whereby power is used to drive a fan or a pump to move a working fluid through the heat sink. The working fluid may transfer the heat to a radiator located with or separate to the heat sink. The assembly may be part of a larger apparatus such as a power converter.

Power converters are used to exchange energy between electrical networks, such as alternating current networks and direct current networks or networks operating at different voltages or frequencies. Often power converters comprise arrays of semiconductor devices or switches, each of which may require cooling. Further, each semiconductor device may be configured to operate in association with other electrical components that also require cooling. Thus, it will be appreciated that providing temperature control for an electrical assembly of interconnected electrical components can be complicated. This is particularly so when access to individual components for maintenance may be required.

The following examples describe a heat sink arrangement for a semiconductor device, such as a thyristor, that is typically arranged in a stack, known as a clamped assembly, comprising a plurality of semiconductor devices arranged together. In particular, the electrical assembly described below has particular application when applied to a plurality of thyristors electrically connected together and that are interleaved by heat sinks, where the thyristor/heat sink stack are secured together by a clamping arrangement. The stack may form part of a power converter. Each thyristor may form part of a thyristor valve with other electrical components (such as secondary electrical components as described below). It will, however, be appreciated that the electrical assembly has wider application and may be used to provide an efficiently cooled electrical assembly comprising arrays of semiconductor devices that is space efficient and easy to maintain.

Figures 1a and 1b show an electrical assembly 1 comprising a primary heat sink 2 and a secondary heat sink 3. Figure 1a shows the primary heat sink 2 and the secondary heat sink 3 releasably coupled together and in thermal contact with one another. Figure 1b shows the primary heat sink 2 and the secondary heat sink 3 decoupled and parted from one another. The releasable nature of the coupling between the primary heat sink 2 and the secondary heat sink 3 is advantageous for servicing of electrical components associated with the heat sinks as described below.

The primary heat sink 2 has a primary electrical component 4 mounted thereon comprising a semiconductor device, such as a thyristor. Thus, the primary heat sink 2 is thermally connected to the primary electrical component 4 such that heat generated by the primary electrical component 4 during use is conducted away by the primary heat sink 4. Although the primary electrical component 4 comprises a thyristor in this example, it may comprise other semiconductor devices such as an insulated-gate bipolar transistor (IGBT), a gate-turn-off thyristor (GTO), a Gate Commutated Thyristor (GCT), an Integrated Gate Commutated Thyristor (IGCT) and an Injection Enhanced Gate Transistor (IEGT).

The secondary heat sink 3 has a secondary electrical component 5 mounted thereon, such as a resistor. Thus, the secondary heat sink 3 is thermally connected to the secondary electrical component 5 such that heat generated by the secondary electrical component 5 during use is conducted away by the secondary heat sink 3. In this example, a plurality of electrical components are mounted on the secondary heat sink 3. Figures 1a and 1b show four grading resistors 5a, 5b, 5c, 5d mounted to the secondary heat sink. The grading resistors may be directly or indirectly electrically connected with the primary electrical component 4.

The primary heat sink 2 and the secondary heat sink 3 are physically releasably couplable to one another. Thus, when brought into contact a retention arrangement may physically hold the primary heat sink 2 and the secondary heat sink 3 in thermal contact. Thus, thermal energy received by the heat sinks can flow between them by virtue of the thermal contact therebetween. Accordingly, each heat sink 2, 3 includes a heat transfer surface 6, 7 through which heat is transferred to the other heat sink when the surfaces 6, 7 abut (shown in Figure 1a) and are in thermal contact.

This arrangement is particularly advantageous for forming a stack of semiconductor devices such as for use in a power converter.

The primary heat sink 2 comprises a plate shaped body 8. The plate is substantially cuboidal having at least a larger, top, face 9 and a second larger, bottom, face 10 that separate four smaller faces 11, 12 (the other two smaller faces are not visible in the sectional view of figure 1 and 2). The primary heat sink may be of a thermally conductive material such as copper or aluminium. The primary heat sink may also be of a metal or other electrically conductive material. The primary electrical component 4 is mounted on one of the larger faces 9. The second larger face 10 is complementary to a side 13 of the primary electrical component 4 that is opposed to the side in contact with the primary heat sink 2. Thus, a plurality of the primary heat sinks and primary electrical components can be stacked together with the faces 9, 10 in contact with interleaved primary electrical components 4. It will be appreciated that one of the primary heat sinks located at one end of the stack will only be in contact with its associated primary electrical component rather and not the primary electrical component of an adjacent primary heat sink. Further, it will be appreciated that one of the primary electrical components located on a primary heat sink located at the other end of the stack may only be in contact with its associated primary heat sink rather than being sandwiched between two primary heat sinks.

The primary heat sink 2 may be actively cooled by a heat transfer fluid that is pumped through the primary heat sink 2. Thus, the primary heat sink 2 includes part of a cooling circuit 14 to receive a flow of heat transfer fluid. The smaller face 11 includes a first port 15 to provide for flow into the cooling circuit part 14 and a second port 16 for flow out of the cooling circuit part 14. The ports 15, 16 may connect to a pump (not shown) and a heat exchanger (not shown). Thus, a heat transfer fluid that enters via one of the ports 15, 16 is transferred around the internal structure of the primary heat sink 2 to absorb the thermal energy of the primary heat sink 2 and then flows back out of the primary heat sink 2. In this example, the heat transfer fluid may be water, although other heat transfer fluids, such as glycol or a mixture of water and glycol may be used.

In this example, the cooling circuit part 14 remains solely within the primary heat sink 2 and does not extend to the secondary heat sink 3. However, in other embodiments, the cooling circuit 14 may include ports to circulate heat transfer fluid from the primary heat sink 2 around the secondary heat sink 3. In still further embodiments, the secondary heat sink 3 is actively cooled by a separate heat transfer fluid circuit, which may utilise the same or different pump and/or the same or different heat exchanger.

Figures 1a and 1b shows a passive secondary heat sink 3. The secondary heat sink 3 does not receive a heat transfer fluid to remove heat therefrom and instead relies upon heat transfer to the environment, such as through fins and the like, and heat transfer into the primary heat sink 2. Thus, the coupling of the passive, secondary heat sink 3 to the actively cooled, primary heat sink 2 via a thermally coupled releasable connection is advantageous in terms of effectively cooling the electrical components of the secondary heat sink while ensuring easy maintenance of the assembly. Thus, replacement of the secondary electrical component is straightforward as the secondary heat sink can be mechanically decoupled from the primary heat sink to either replace the whole arrangement including the secondary electrical components or just provide convenient access to the secondary electrical components for replacement in a position decoupled from the electrical assembly 1. Thus, if the secondary heat sink is a passive heat sink, a user advantageously does not have to open or disconnect the cooling circuit 14.

The smaller face 12 comprises the heat transfer surface 6 of the primary heat sink 2. Given that the primary heat sink 2 is plate shaped, the faces 11, 12 have a relatively smaller area than the larger faces 9, 10. Thus, in order to provide a larger surface area for heat transfer between the secondary heat sink 3 and the primary heat sink 2, the face 12 may include one or more projections or recesses. The projections or recesses are complementary to the other of a projection or recess formed on the secondary heat sink 3. The projection and recess thus comprise a plug and socket configuration comprising a male plug part and a female socket part. In this example, the heat transfer surface of the primary heat sink 6 comprises one projection 17, although more projections could be provided. The projection may be wedge shaped such that it tapers to a narrower portion at its distal end. A tapering shape makes mounting of the secondary heat sink 3 to the primary heat sink 2 easier. The projection 17 has a length of more than 10%, 20%, 30%, 40% or 50% of the length of the primary heat sink measured between the face 11 and the base of the projection 17. This increases the area of the heat transfer surface so that the passive, secondary heat sink 3 is able to rely on the cooling effect of the primary heat sink 2 in addition to any direct heat transfer to atmosphere. Further, the cooling circuit part 14 follows a path that extends into the internal volume of the projection 17. In other embodiments the path does not extend into the projection 17. A layer of thermal grease may be provided between the projection and recess to provide for effective thermal coupling.

The secondary heat sink 3, in this example, is also flat and substantially plate shaped and therefore also includes two larger faces separated by four smaller faces and is connected to the primary heat sink via the smaller face 18. The face 18 includes a recess 19 complementary to the projection 17. The heat transfer surface 7 is provided over the internal surface of the recess 19. The secondary electrical component 5 is mounted on at least one of the larger faces 20 or one of the smaller faces 21, opposite the face 18 that connects to the primary heat sink 2. The secondary heat sink 3 can be considered to be a detachable extension of the primary heat sink 2. The secondary heat sink may be of a thermally conductive material such as copper or aluminium. The secondary heat sink may also be of a metal or other electrically conductive material.

The primary heat sink 2 and the secondary heat sink 3 are held in contact with one another by a mechanical retention arrangement. In this example, an interference fit between the projection 17 and the recess 19 provides for the mechanical retention. The thermal coupling is provided by the surface 7 being in close contact with the surface 6 when the primary and secondary heat sinks are coupled together.

The heat sinks 2, 3 described above are plate shaped although they may be any shape. When the semiconductor device 4 is a switching device for a high voltage power converter it is advantageous for a plurality of primary heat sinks to be arranged interleaved with a corresponding plurality of semiconductor devices and for the secondary heat sinks to project from the primary heat sinks such that they can be decoupled from their associated primary heat sink without disassembly of the interleaved primary heat sink arrangement.

Electrical connections between the primary electrical component 4 and the secondary electrical component 5 may also be provided. In some examples, the electrical conductivity of the primary and secondary heat sinks may be utilised to provide an electrical connection between the components.

The secondary electrical components 5 may comprise components electrically arranged with the semiconductor device 4 to form a circuit, such as a switching circuit of a power converter. In this example, the secondary electrical components 5 comprise one or more grading resistors to improve the distribution (grading) of voltage amongst the series connected semiconductor devices in the circuit. However, in other examples, the secondary electrical component may comprise a capacitor, such as a snubber capacitor configured to suppress voltage transients during switching of the semiconductor device; a controller configured to control, monitor or provide feedback from the semiconductor device. Thus, the controller may be configured to control one or more of the semiconductor devices of the primary heat sink. The controller may be configured to provide a turn-on signal to the semiconductor device; a turn-off signal to the semiconductor device; and/or a feedback signal based on the conduction state of the semiconductor device.

Figure 2 shows the electrical assembly 1 comprising a stack of primary and secondary heat sinks 2, 3 with their associated primary and secondary electrical components 4, 5. The stack comprises two of the arrangement shown in Figure 1 stacked on top of one another with the primary heat sinks and associated primary electrical components clamped together to form a clamped assembly. The same reference numerals have been used for like parts.

Each individual arrangement of primary and secondary heat sink 2, 3 and primary and secondary electrical component 4, 5 is substantially the same as described for Figure 1. Therefore only the differences will be described. Further, to distinguish between the two heat sink/component arrangement in the stack, they will be designated the first arrangement 22 and the second arrangement 23. The second arrangement 23 is mounted with the first arrangement 22 such that the face 10 of the second arrangement 23 contacts the primary electrical component 4 of the first arrangement 22. The contact between the primary electrical component 4 of the first arrangement 22 and the primary heat sink 2 of second arrangement 23 may be such that the primary electrical component 4 is thermally coupled to both its associated primary heat sink 2 and an adjacent primary heat sink 2 (of arrangement 23) in the stack. As mentioned above, an electrical connection may be provided between one terminal of the semiconductor device to its associated primary heat sink and an electrical connection may be provided between a second terminal and the primary heat sink of the adjacent arrangement. The first and second terminals may comprise the anode and the cathode of the thyristor 4. Further, in the case of the primary electrical component comprising an IGBT or IEGT, the first and second terminals may comprise the collector and emitter of the IGBT or IEGT.

A clamping arrangement (not shown) is configured to clamp groups of heat sink/electrical component arrangements, 2, 4 together. The clamping arrangement may provide physical integrity to the stack and may ensure good thermal coupling between the primary electrical components 4 and the primary heat sinks 2 that surround them.

Figure 2 also shows that the secondary heat sinks 3 and/or their associated secondary electrical components 5 are arranged such that there is a gap 24 between adjacent secondary heat sinks 3. The gap 24 may provide for easier maintenance to the secondary electrical components, as the secondary heat sink 3 can be removed without releasing the clamping arrangement that holds the stack together by the primary heat sinks 2 and the primary electrical components 4. Further, the gap 24 provides for electrical isolation between the secondary heat sinks, which may be important because the secondary heat sinks on either side of the gap may be at different electrical potentials when the primary semiconductor device is in the off state.

Figure 2 also shows additional secondary electrical components 5 mounted on the secondary heat sink 3. In particular, box 5e, mounted to the face 21 of the secondary heat sink 3, represents one or more secondary electrical components that may or may not be provided with cooling by the secondary heat sink. In this example, the box 5e represents one or more grading resistors, one or more grading capacitors, one or more snubber capacitors and/or control electronics. The electrical components of box 5e may be electrically connected to the primary electrical component 4 and/or the other secondary electrical components 5a-d.

Electrical connections between the primary and secondary electrical components may be provided. Further electrical connections between secondary electrical components of adjacent (but could be elsewhere in the stack) arrangements 22, 23 may be provided. A gate electrical connection 25 comprising an electrical cable or an optical cable is provided between a controller that forms part of the electrical components 5e and the gate terminal of the primary electrical component (thyristor) 4. An anode electrical connection 26 is provided between the secondary electrical components 5e of the first arrangement 22 and the secondary electrical components 5e of the second arrangement 23. The anode connection may comprise an electrical cable. A cathode electrode connection is provided for by the conductivity of the primary heat sink 2 and the secondary heat sink 3. Accordingly, a cathode terminal of the primary electrical component 4 is connected to a terminal of one or more of the secondary electrical components via the electrical connection provided by the body of the heat sinks 2, 3.

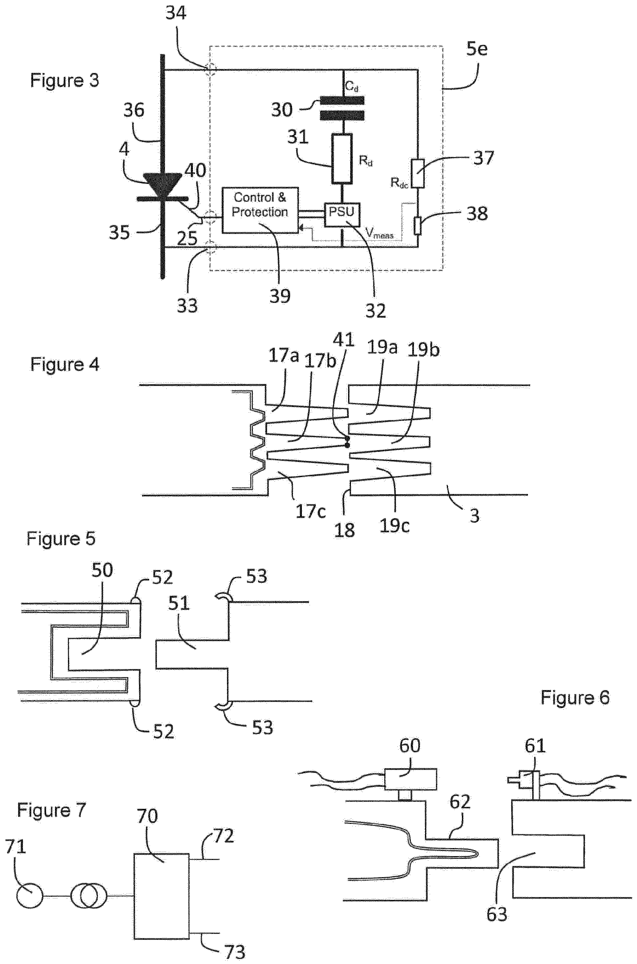

Figure 3 shows the secondary electrical components in the box 5e and the connection to the primary electrical components, which comprises thyristor 4. The resistors 5a-d are shown schematically as within box 5e in Figure 3 for clarity. The secondary electrical components comprise a capacitor 30 and a resistor 31 and a power supply unit (PSU) 32 arranged in series with one another. The capacitor 30, resistor 31 and PSU 32 are arranged in parallel with the thyristor 4 by way of the cathode electrical connection (shown as 33) and the anode electrical connection 34. The cathode electrical connection 33 connects to a cathode terminal 35 of the thyristor 4. The anode electrical connection 34 connects to an anode terminal 36 of the thyristor 4. The capacitor 30, resistor 31 and PSU 32 are also arranged in parallel with a pair of resistors 37, 38 that are arranged in series. A connection internal to the secondary electrical components 5e provides a signal Vₘₑₐₛ to a controller 39 from between the pair of resistors 37, 38. Thus, the pair of resistors 37, 38 act as a voltage divider for the voltage across the thyristor 4 and as the grading resistors (resistors 5a-d) to improve voltage distribution between series-connected thyristors. The controller 39, which may comprise a microcontroller or ASIC for example, is provided with power from the PSU 32. The controller 39 is configured to provide a control signal to a gate terminal 40 of the thyristor 4 by the gate electrical connection 25 and/or provide monitoring functions of the state of the thyristor 4.

Figure 4 shows a further embodiment of the connection between the primary heat sink 2 and the secondary heat sink 3. In this embodiment, the face 12 of the primary heat sink includes a plurality of projections 17a, 17b, 17c. Likewise, the face 18 of the secondary heat sink 3 includes a plurality of complementary recesses 19a, 19b, 19c. In this example, the heat transfer fluid circuit part 14 does not extend into the projections 17a, 17b, 17c. One or more of the projections 17a-c and, in this case projection 17b, includes a flange 41. The flange 41 is configured to cooperate with a complementary detent structure (not shown) of the face 18 and/or heat transfer surface 7. The flange 41 acts to physically retain the primary and secondary heat sink in close thermal contact.

Figure 5 shows a further embodiment where the primary heat sink 2 includes a socket or recess 50 and the secondary heat sink 3 includes the projection or plug 51. Rather than being tapered as in previous examples, the projection and recess 50, 51 have a substantially constant width along their length. The heat transfer fluid circuit part 14 is also shown extending around side walls of the recess 50 within the body of the primary heat sink 2. In this example, the retention element comprises a flange 52 and a clip 53 arranged to engage one another when the primary heat sink 2 and the secondary heat sink are coupled together. The clip 53 rides over the flange 52 to provide a secure mechanical engagement between the heat sinks. In other examples, the retention element comprises a magnetic coupling.

Figure 6 shows a further example similar to Figure 5 in which the projection and recess 62, 63 are provided on the other of the primary and secondary heat sink 2, 3. In this example, the primary and secondary heat sinks also carry complementary parts of an electrical connector 60, 61. The electrical connector parts are configured to electrically connect together when the primary and secondary heat sinks 2, 3 are in mechanical and thermal engagement with one another. Alternatively, the electrical connector parts may require manual connection. The electrical connector part 60 of the primary heat sink carries connections to one or more of the terminals of the primary electrical component 4. The electrical connector part 61 of the secondary heat sink 3 carries connections to one or more of the terminals of one or more of the components of the secondary electrical components 5. Thus, the electrical connector provides a convenient means for electrically connecting the primary and secondary electrical components. The retention element for physically retaining the heat sinks together is provided by an interference fit between the projection and recess 62, 63.

In other embodiments, a plurality of primary electrical components may be provided on said primary heat sink. In other embodiments, the secondary heat sink may include at least one heat pipe having a working fluid therein for transferring thermal energy from an evaporator end to a condensing end, the condensing end arranged adjacent the heat transfer surface of the secondary heat sink. Thus, a heat pipe comprises a sealed body including a phase-change working fluid that absorbs heat at one end, evaporates, and transfers the heat to the condensing end. The working fluid is transferred back to the evaporator end by a wick within the heat pipe.

In other embodiments, the stack may comprise a stack of thyristors that may or may not be interleaved with primary heat sinks and the primary heat sinks may attach to the thyristors on any available thyristor surface.

A power converter 70 comprising, a LCC or VSC, may include a stack wherein the semiconductor devices 4 are configured to provide switching of a voltage between an AC network 71 and DC electrical network represented by DC terminals 72, 73. The assembly 1, comprising a stack, may form part of a limb of the converter 70 for switching a voltage of an electrical phase of the AC network or the voltage of the DC network, as will be understood by those skilled in the art.

## Claims

1. An electrical assembly comprising;
a plurality of primary electrical components (4), each comprising a semiconductor device;
a plurality of primary heat sinks (2), each having a primary electrical component (4) mounted thereon to provide a heat sink for the primary electrical component (4);
a plurality of secondary electrical components (5), each electrically connected or coupled with a primary electrical component (4);
a plurality of secondary heat sinks (3), each having the secondary electrical component (5) mounted thereon to provide a heat sink for the secondary electrical component (5);
wherein the plurality of primary heat sinks (2) and associated primary electrical components (4) are arranged in a stack wherein, in the stack, a second primary heat sink (3) is positioned adjacent a first primary heat sink (2) in the stack and is arranged such the primary electrical component (4) of the first primary heat sink (2) is clamped between the first primary heat sink (2) and the second primary heat sink (3) by a clamping arrangement and wherein each primary heat sink (2) and the adjacent secondary heat sink (3) are physically releasably couplable to one another and, when coupled, the primary and secondary heat sinks (2, 3) are thermally coupled by abutment of respective heat transfer surfaces (6, 7) of the primary and secondary heat sinks (2, 3).

2. An electrical assembly according to claim 1, in which each primary heat sink (2) is configured to receive a flow of a heat transfer fluid to actively cool said primary heat sink (2).

3. An electrical assembly according to claim 1 or claim 2, in which each secondary heat sink (3) is configured to passively cool the secondary electrical component (5) without a flow of heat transfer fluid at least by virtue of its thermal coupling with the primary heat sink (2).

4. An electrical assembly according to any preceding claim, in which each primary heat sink (2) and the adjacent secondary heat sink (3) include complementary parts (17, 19) of a releasable physical retention element configured to physically hold the primary and secondary heat sinks (2, 3) together when coupled.

5. An electrical assembly according to any preceding claim, in which each primary heat sink (2) includes one of a projecting plug part (17, 51) and a complementary socket part (19, 50) and the adjacent secondary heat sink (3) includes the other, the plug part (17, 51) configured to be received by the socket part (19, 51) when the primary heat sink (2) and the secondary heat sink (3) are coupled, the plug part (17, 51) and socket part (19, 50) each comprising the respective heat transfer surface (6, 7) to transfer heat between the secondary heat sink (3) and the primary heat sink (2).

6. An electrical assembly according to any preceding claim, in which the secondary heat sinks (3) of the stack are arranged relative to the primary heat sinks (2) such that they are individually removable from their associated primary heat sink (2) without unclamping of the clamping arrangement of the primary heat sinks (2) in the stack.

7. An electrical assembly according to any preceding claim, in which each semiconductor device (4) comprises one or more of; a thyristor; an insulated-gate bipolar transistor (IGBT); a gate-turn-off thyristor (GTO); a Gate Commutated Thyristor (GCT); an Integrated Gate Commutated Thyristor (IGCT); and an Injection Enhanced Gate Transistor (IEGT).

8. An electrical assembly according to any preceding claim, in which each secondary electrical component (5) comprises at least one of;
a grading resistor (5a-c) comprising a resistor configured to improve the distribution (grading) of voltage amongst series connected semiconductor devices (4) in the electrical assembly;
a snubber capacitor comprising a capacitor configured to suppress voltage transients during switching of the semiconductor device;
a damping circuit such as a Resistor-Capacitor circuit (30, 31) configured to damp any oscillatory behaviour experienced at switching of the semiconductor device (4); a controller (39) configured to control, monitor or provide feedback from the semiconductor device (4).

9. An electrical assembly according to any preceding claim, in which each secondary heat sink (3) includes at least one heat pipe having a working fluid therein for transferring thermal energy from an evaporator end to a condensing end, the condensing end arranged adjacent the heat transfer surface (7) of the secondary heat sink (3).

10. An electrical assembly according to any preceding claim, in which each primary heat sink 92) comprises a plate having a first and a second larger face (9, 10) and four smaller faces (11, 12), wherein the primary electrical component (4) is mounted to at least one of the larger faces (9, 10) and the secondary heat sink (3) is thermally coupled to one of the smaller faces (11, 12).

11. An electrical assembly according to any preceding claim, including an electrical connector comprising a first electrical connector part and a second electrical connector part (26) for providing an electrical connection between the semiconductor device (4) and the secondary electrical component (5), the first electrical connector part associated with the primary heat sink (2) and the second electrical connector part (26) associated with the secondary heat sink (3).

12. An electrical assembly according to any preceding claim, in which each primary heat sink (2) and adjacent secondary heat sink (3) are of an electrically conductive material and the coupling between them provides for an electrical connection therebetween, wherein an electrical terminal of the primary electrical component (4) and an electrical terminal of the adjacent secondary electrical component (5) are connected together via the first and secondary heat sinks (2, 3) such that a current path between the primary and secondary electrical components (4, 5) is provided by the heat sinks (2, 3).

13. A converter (70), for transferring power between AC and DC electrical networks (71, 72, 73), comprising a converter limb portion connected between AC and DC terminals, the AC terminal being connectable to an AC electrical network (71) and the DC terminal being connectable to a DC electrical network (71, 72), the converter limb portion including the electrical assembly of any one of claims 1 to 12, wherein the semiconductor device (4) comprises a switching element operable to facilitate power transfer between the AC and DC terminals during operation of the converter (70).

## Patentansprüche

1. Elektrische Baugruppe, umfassend;
eine Vielzahl von primären elektrischen Komponenten (4), die jeweils eine Halbleitervorrichtung umfassen;
eine Vielzahl von primären Kühlkörpern (2), auf denen jeweils eine primäre elektrische Komponente (4) angebracht ist, um einen Kühlkörper für die primäre elektrische Komponente (4) bereitzustellen;
eine Vielzahl von sekundären elektrischen Komponenten (5), die jeweils mit einer primären elektrischen Komponente (4) elektrisch verbunden oder gekoppelt sind;
eine Vielzahl von sekundären Kühlkörpern (3), wobei jeder die sekundäre elektrische Komponente (5) aufweist, die darauf angebracht ist, um einen Kühlkörper für die sekundäre elektrische Komponente (5) bereitzustellen;
wobei die Vielzahl von primären Kühlkörpern (2) und zugehörigen primären elektrischen Komponenten (4) in einem Stapel angeordnet sind, wobei in dem Stapel ein zweiter primärer Kühlkörper (3) benachbart zu einem ersten primären Kühlkörper (2) in dem Stapel positioniert und so angeordnet ist, dass die primäre elektrische Komponente (4) des ersten primären Kühlkörpers (2) zwischen dem ersten primären Kühlkörper (2) und dem zweiten primären Kühlkörper (3) durch eine Klemmanordnung geklemmt ist, und wobei jeder primäre Kühlkörper (2) und der benachbarte sekundäre Kühlkörper (3) physikalisch lösbar miteinander koppelbar sind und, wenn sie gekoppelt sind, die primären und sekundären Wärmesenken (2, 3) thermisch gekoppelt sind, indem die jeweiligen Wärmeübertragungsflächen (6, 7) der primären und sekundären Wärmesenken (2, 3) aneinander stoßen.

2. Elektrische Baugruppe nach Anspruch 1, wobei jeder primäre Kühlkörper (2) so konfiguriert ist, dass er eine Strömung eines Wärmeübertragungsfluids erhält, um den primären Kühlkörper (2) aktiv zu kühlen.

3. Elektrische Baugruppe nach Anspruch 1 oder Anspruch 2, wobei jeder sekundäre Kühlkörper (3) so konfiguriert ist, dass er die sekundäre elektrische Komponente (5) zumindest aufgrund seiner thermischen Kopplung mit dem primären Kühlkörper (2) ohne einen Strom von Wärmeübertragungsfluid passiv kühlt.

4. Elektrische Baugruppe nach einem der vorstehenden Ansprüche, wobei jeder primäre Kühlkörper (2) und der benachbarte sekundäre Kühlkörper (3) komplementäre Teile (17, 19) eines lösbaren physikalischen Rückhalteelements beinhalten, das so konfiguriert ist, dass es die primären und sekundären Kühlkörper (2, 3) physikalisch zusammenhält, wenn sie gekoppelt sind.

5. Elektrische Baugruppe nach einem der vorstehenden Ansprüche, wobei jeder primäre Kühlkörper (2) ein vorstehendes Steckerteil (17, 51) oder ein komplementäres Buchsenteil (19, 50) beinhaltet und der benachbarte sekundäre Kühlkörper (3) das andere beinhaltet, wobei das Steckerteil (17, 51) so konfiguriert ist, dass es von dem Buchsenteil (19, 51) aufgenommen werden kann, wenn der primäre Kühlkörper (2) und der sekundäre Kühlkörper (3) gekoppelt sind, wobei das Steckerteil (17, 51) und das Buchsenteil (19, 50) jeweils die entsprechende Wärmeübertragungsfläche (6, 7) umfassen, um Wärme zwischen dem sekundären Kühlkörper (3) und dem primären Kühlkörper (2) zu übertragen.

6. Elektrische Baugruppe nach einem der vorstehenden Ansprüche, wobei die sekundären Kühlkörper (3) des Stapels relativ zu den primären Kühlkörpern (2) so angeordnet sind, dass sie einzeln von ihrem zugehörigen primären Kühlkörper (2) entfernbar sind, ohne die Klemmanordnung der primären Kühlkörper (2) in dem Stapel zu entklemmen.

7. Elektrische Baugruppe nach einem der vorstehenden Ansprüche, wobei jede Halbleitervorrichtung (4) einen oder mehrere der Folgenden umfasst: einen Thyristor, einen Bipolartransistor mit isoliertem Gate (IGBT), einen Abschaltthyristor (GTO), einen gate-kommutierten Thyristor (GCT), einen integrierten gate-kommutierten Thyristor (IGCT) und einen injektionsverstärkten Gate-Transistor (IEGT).

8. Elektrische Baugruppe nach einem der vorstehenden Ansprüche, wobei jede sekundäre elektrische Komponente (5) mindestens eines der Folgenden umfasst:
einen Einstufungswiderstand (5a-c), der einen Widerstand umfasst, der so konfiguriert ist, dass er die Verteilung (Einstufung) der Spannung zwischen in Reihe geschalteten Halbleitervorrichtungen (4) in der elektrischen Baugruppe verbessert;
einen Dämpfungskondensator, der einen Kondensator umfasst, der so konfiguriert ist, dass er Spannungstransienten während des Schaltens der Halbleitervorrichtung unterdrückt; einer Dämpfungsschaltung, wie einer Widerstands-Kondensator-Schaltung (30, 31), die so konfiguriert ist, dass sie jegliches Schwingungsverhalten dämpft, das beim Schalten der Halbleitervorrichtung (4) auftritt;
eine Steuerung (39), die so konfiguriert ist, dass sie die Halbleitervorrichtung (4) steuert, überwacht oder eine Rückkopplung von dieser bereitstellt.

9. Elektrische Baugruppe nach einem der vorstehenden Ansprüche, wobei jeder sekundäre Kühlkörper (3) mindestens eine Wärmeleitung mit einem Arbeitsfluid darin zum Übertragen von Wärmeenergie von einem Verdampferende zu einem Kondensationsende beinhaltet, wobei das Kondensationsende benachbart zu der Wärmeübertragungsfläche (7) des sekundären Kühlkörpers (3) angeordnet ist.

10. Elektrische Baugruppe nach einem der vorstehenden Ansprüche, wobei jeder primäre Kühlkörper (92) eine Platte mit einer ersten und einer zweiten größeren Seite (9, 10) und vier kleineren Seiten (11, 12) aufweist, wobei die primäre elektrische Komponente (4) an mindestens einer der größeren Seiten (9, 10) angebracht ist und der sekundäre Kühlkörper (3) thermisch mit einer der kleineren Seiten (11, 12) gekoppelt ist.

11. Elektrische Baugruppe nach einem der vorstehenden Ansprüche, einschließlich eines elektrischen Verbinders mit einem ersten elektrischen Verbinderteil und einem zweiten elektrischen Verbinderteil (26) zur Bereitstellung einer elektrischen Verbindung zwischen der Halbleitervorrichtung (4) und der sekundären elektrischen Komponente (5), wobei das erste elektrische Verbinderteil dem primären Kühlkörper (2) und das zweite elektrische Verbinderteil (26) dem sekundären Kühlkörper (3) zugeordnet ist.

12. Elektrische Baugruppe nach einem der vorstehenden Ansprüche, wobei jeder primäre Kühlkörper (2) und der benachbarte sekundäre Kühlkörper (3) aus einem elektrisch leitfähigen Material bestehen und die Kopplung zwischen ihnen eine elektrische Verbindung zwischen ihnen bereitstellt, wobei ein elektrischer Anschluss der primären elektrischen Komponente (4) und ein elektrischer Anschluss der benachbarten sekundären elektrischen Komponente (5) über den ersten und den sekundären Kühlkörper (2, 3) miteinander verbunden sind, so dass ein Strompfad zwischen der primären und der sekundären elektrischen Komponente (4, 5) durch die Kühlkörper (2, 3) bereitgestellt wird.

13. Wandler (70) zur Übertragung von Leistung zwischen elektrischen Wechselstromund Gleichstromnetzwerken (71, 72, 73), mit einem Wandlerschenkelabschnitt, der zwischen Wechselstrom- und Gleichstromanschlüssen angeschlossen ist, wobei der Wechselstromanschluss an ein elektrisches Wechselstromnetzwerk (71) und der Gleichstromanschluss 25 an ein elektrisches Gleichstromnetzwerk (71, 72) anschließbar ist, wobei der Wandlerschenkelabschnitt die elektrische Baugruppe nach einem der Ansprüche 1 bis 12 umfasst, wobei die Halbleitervorrichtung (4) ein Schaltelement umfasst, das betreibbar ist, um die Leistungsübertragung zwischen den Wechselstromund Gleichstromanschlüssen während des Betriebs des Wandlers (70) zu erleichtern.

## Revendications

1. Ensemble électrique comprenant :
une pluralité de composants électriques primaires (4), comprenant chacun un dispositif à semi-conducteur ;
une pluralité de puits de chaleur primaires (2), ayant chacun un composant électrique primaire (4) monté sur celui-ci pour fournir un puits de chaleur pour le composant électrique primaire (4) ;
une pluralité de composants électriques secondaires (5), chacun connecté électriquement ou couplé à un composant électrique primaire (4) ;
une pluralité de puits de chaleur secondaires (3), chacun ayant le composant électrique secondaire (5) monté sur celui-ci pour fournir un puits de chaleur pour le composant électrique secondaire (5) ;
dans lequel la pluralité de puits de chaleur primaires (2) et de composants électriques primaires (4) associés sont agencés en un empilement dans lequel, dans l'empilement, un second puits de chaleur primaire (3) est positionné adjacent à un premier puits de chaleur primaire (2) dans l'empilement et est agencé de sorte que le composant électrique primaire (4) du premier puits de chaleur primaire (2) soit serré entre le premier puits de chaleur primaire (2) et le second puits de chaleur primaire (3) par un agencement de serrage et dans lequel chaque puits de chaleur primaire (2) et le puits de chaleur secondaire (3) adjacent peuvent être couplés de manière libérable physiquement l'un à l'autre et, lorsqu'ils sont couplés, les puits de chaleur primaire et secondaire (2, 3) sont couplés thermiquement par butée de surfaces de transfert de chaleur (6, 7) respectives des puits de chaleur primaire et secondaire (2, 3).

2. Ensemble électrique selon la revendication 1, dans lequel chaque puits de chaleur primaire (2) est configuré pour recevoir un flux d'un fluide de transfert thermique afin de refroidir activement ledit puits de chaleur primaire (2).

3. Ensemble électrique selon la revendication 1 ou la revendication 2, dans lequel chaque puits de chaleur secondaire (3) est configuré pour refroidir passivement le composant électrique secondaire (5) sans flux de fluide de transfert thermique au moins grâce à son couplage thermique avec le puits de chaleur primaire (2).

4. Ensemble électrique selon l'une quelconque des revendications précédentes, dans lequel chaque puits de chaleur primaire (2) et le puits de chaleur secondaire (3) adjacent comportent des parties complémentaires (17, 19) d'un élément de retenue physique libérable configuré pour tenir physiquement les puits de chaleur primaire et secondaire (2, 3) ensemble lorsqu'ils sont couplés.

5. Ensemble électrique selon l'une quelconque des revendications précédentes, dans lequel chaque puits de chaleur primaire (2) comporte l'une d'une partie mâle en saillie (17, 51) et d'une partie femelle complémentaire (19, 50) et le puits de chaleur secondaire (3) adjacent comporte l'autre, la partie mâle (17, 51) étant configurée pour être reçue par la partie femelle (19, 51) lorsque le puits de chaleur primaire (2) et le puits de chaleur secondaire (3) sont couplés, la partie mâle (17, 51) et la partie femelle (19, 50) comprenant chacune la surface de transfert thermique (6, 7) respective pour transférer de la chaleur entre le puits de chaleur secondaire (3) et le puits de chaleur primaire (2).

6. Ensemble électrique selon l'une quelconque des revendications précédentes, dans lequel les puits de chaleur secondaires (3) de l'empilement sont agencés par rapport aux puits de chaleur primaires (2) de sorte qu'ils soient individuellement amovibles de leur puits de chaleur primaire (2) associé sans desserrage de l'agencement de serrage des puits de chaleur primaires (2) dans l'empilement.

7. Ensemble électrique selon l'une quelconque des revendications précédentes, dans lequel chaque dispositif à semi-conducteur (4) comprend un ou plusieurs parmi : un thyristor ; un transistor bipolaire à grille isolée (IGBT) ; un thyristor à extinction par la gâchette (GTO) ; un thyristor à commutation de grille (GCT) ; un thyristor à commutation de grille intégré (IGCT) ; et un transistor à grille amélioré par injection (IEGT).

8. Ensemble électrique selon l'une quelconque des revendications précédentes, dans lequel chaque composant électrique secondaire (5) comprend au moins l'un parmi :
un résistor de répartition (5a à c) comprenant un résistor configuré pour améliorer la distribution (répartition) de tension parmi des dispositifs à semi-conducteur (4) connectés en série dans l'ensemble électrique ;
un condensateur d'amortissement comprenant un condensateur configuré pour supprimer des transitoires de tension pendant une commutation du dispositif à semi-conducteur ;
un circuit atténuateur tel qu'un circuit résistor-condensateur (30, 31) configuré pour atténuer un comportement oscillatoire survenant à la commutation du dispositif à semi-conducteur (4) ;
un dispositif de commande (39) configuré pour commander, surveiller ou fournir une rétroaction provenant du dispositif à semi-conducteur (4).

9. Ensemble électrique selon l'une quelconque des revendications précédentes, dans lequel chaque puits de chaleur secondaire (3) comporte au moins un tube caloporteur ayant un fluide de travail dans celui-ci pour transférer de l'énergie thermique d'une extrémité d'évaporateur à une extrémité de condensation, l'extrémité de condensation étant agencée adjacente à la surface de transfert thermique (7) du puits de chaleur secondaire (3).

10. Ensemble électrique selon l'une quelconque des revendications précédentes, dans lequel chaque puits de chaleur primaire (2) comprend une plaque ayant une première et une seconde face plus grandes (9, 10) et quatre faces plus petites (11, 12), dans lequel le composant électrique primaire (4) est monté sur au moins l'une des faces plus grandes (9, 10) et le puits de chaleur secondaire (3) est couplé thermiquement à l'une des faces plus petites (11, 12).

11. Ensemble électrique selon l'une quelconque des revendications précédentes, comportant un connecteur électrique comprenant une première partie de connecteur électrique et une seconde partie de connecteur électrique (26) pour fournir une connexion électrique entre le dispositif à semi-conducteur (4) et le composant électrique secondaire (5), la première partie de connecteur électrique étant associée au puits de chaleur primaire (2) et la seconde partie de connecteur électrique (26) étant associée au puits de chaleur secondaire (3).

12. Ensemble électrique selon l'une quelconque des revendications précédentes, dans lequel chaque puits de chaleur primaire (2) et le puits de chaleur secondaire (3) adjacent sont constitués d'un matériau électriquement conducteur et le couplage entre eux fournit une connexion électrique entre eux, dans lequel une borne électrique du composant électrique primaire (4) et une borne électrique du composant électrique secondaire (5) adjacent sont connectées ensemble via les puits de chaleur primaire et secondaire (2, 3) de sorte qu'un trajet de courant entre les composants électriques primaire et secondaire (4, 5) soit fourni par les puits de chaleur (2, 3).

13. Convertisseur (70), destiné à transférer une puissance entre des réseaux électriques CA et CC (71, 72, 73), comprenant une portion de branche de convertisseur connectée entre des bornes CA et CC, la borne CA pouvant être connectée à un réseau électrique CA (71) et la borne CC pouvant être connectée à un réseau électrique CC (71, 72), la portion de branche de convertisseur comportant l'ensemble électrique de l'une quelconque des revendications 1 à 12, dans lequel le dispositif à semi-conducteur (4) comprend un élément de commutation capable de fonctionner pour faciliter un transfert de puissance entre les bornes CA et CC pendant un fonctionnement du convertisseur (70).
